# EUROPEAN PATENT SPECIFICATION

(11) **EP 2 237 328 B1**
(45) Date of publication and mention of the grant of the patent: **02.08.2017**
(21) Application number: 09156957.4
(22) Date of filing: 31.03.2009
(51) Int. Cl.: H01L 33/00, H01L 33/60, H01L 23/00, H01L 33/48

(54) **Method for producing a plurality of optoelectronic semiconductor components and optoelectronic semiconductor component**
Verfahren zur Herstellung einer Vielzahl von optoelektronischen Halbleiterkomponenten und optoelektronische Halbleiterkomponente
Procédé pour la production d'une pluralité de composants semi-conducteurs opto-électroniques et composant semi-conducteur opto-électronique

(43) Date of publication of application: 06.10.2010
(73) Proprietor: OSRAM Opto Semiconductors GmbH, 93055 Regensburg (DE)
(72) Inventor: Wong, Lye Yee, 11900 Penang (MY); Chong, Chee Nan, 11900 Penang (MY)
(74) Representative: Epping - Hermann - Fischer

(56) References cited:
- EP-A- 0 921 568
- EP-A1- 1 641 049
- WO-A-02/05357
- US-A1- 2002 187 570
- US-A1- 2006 157 722

## Description

The present application relates to an optoelectronic semiconductor component and to a method for producing a plurality of optoelectronic semiconductor components. Document US 2002/187570 A1 discloses a method for producing a plurality of optoelectronic semiconductor components and an optoelectronic semiconductor component. Furthermore, document EP 1 641 049 A1 discloses an optoelectronic semiconductor component.

The invention is defined by the independent claims. Embodiments of the invention are set out in the dependent claims. A method for producing a plurality of optoelectronic semiconductor components is disclosed. The method comprises forming a multi-component composite. The multi-component composite is separated into individual semiconductor components in a subsequent process step.

In the present context, the expression "multi-component composite" denotes in particular an intermediate product produced in the method. The multi-component composite preferably is one continuous body that comprises the plurality of future semiconductor components.

Formation of the multi-component composite comprises providing a carrier body. During separation of the multi-component composite into individual semiconductor components the carrier body is in particular divided into a plurality of carrier substrates, each carrier substrate being assigned to one semiconductor component.

The carrier body has a chip mounting surface with a plurality of chip mounting regions. Each
chip mounting region is provided for mounting at least one optoelectronic semiconductor chip.

Preferably, the carrier body is free of breakthroughs. In other words, the carrier body preferably does not have a through-hole extending from the chip mounting surface completely through the carrier body to its side opposite the chip mounting surface. In this way, a liquid or a viscous material - for example a casting or molding material - can be easily applied to the chip mounting surface in a subsequent process step. The danger that the liquid / viscous material escapes through the carrier body is advantageously low.

In one embodiment, the carrier body is a carrier plate, for example a circuit board, in particular a printed circuit board. In one development, the carrier plate comprises a ceramic material. In another embodiment, the carrier body comprises a leadframe and a continuous film, for example a plastic film, attached to the leadframe. The continuous film is attached to the leadframe at the side opposite of the chip mounting surface, for example.

The optoelectronic semiconductor chip preferably is a light emitting diode chip (LED-chip). The LED chip is in particular provided for emitting infrared, visible or ultraviolet light. Alternatively, the optoelectronic semiconductor chip or at least one of the optoelectronic semiconductor chips can be a light receiving semiconductor chip.

Formation of the multi-component composite further comprises forming at least one first ridge on the chip mounting surface. Preferably, the first ridge is arranged laterally between two adjacent chip mounting regions.

In particular, at least two first ridges are formed on the chip mounting surface. At least one chip mounting region is laterally sandwiched between the two first ridges. In other words, the two first ridges are arranged on opposite sides of the at least one chip mounting region in top view of the carrier body. In an expedient development, the two first ridges are parallel to each other.

In a preferred embodiment, the chip mounting regions are arranged in a matrix with at least two rows and two columns. In this case, the at least one first ridge preferably runs between two adjacent columns of chip mounting regions. In an embodiment with at least two first ridges, two subsequent first ridges preferably laterally sandwich one column of chip mounting regions.

Separation of the multi-component composite into individual semiconductor components comprises effecting at least one first cut through the carrier body and at least one first ridge along a main extension direction of the first ridge. Preferably for each of the first ridges, a respective first cut is effected through the carrier body and the respective first ridge along a main extension direction of the first ridge. In an embodiment with parallel first ridges, the first cuts are expediently parallel, as well.

With the method, small distances between the chip mounting regions can be achieved during production of the multi-component composite and fast machine cycles are possible. This allows for a cost efficient manufacturing process.

In one embodiment, the two first ridges and the carrier body define a groove, the groove comprising the sandwiched chip mounting region. In one development, formation of the multi-component composite further comprises filling the groove with an encapsulation material like an epoxy resin or silicone resin.

For example, the encapsulation material is radiation transmissive. Preferably, it is transparent or translucent. In particular, it is transparent or translucent at least for electromagnetic radiation with wavelengths which are suitable for emission or reception by the optoelectronic semiconductor chip. In one embodiment the translucent encapsulation material comprises particles of a phosphor and/or diffuser particles. As an alternative to a translucent or transparent encapsulation material, a wavelength-shifting encapsulation material can be provided. The wavelength-shifting encapsulation material absorbs the radiation emitted by the semiconductor chip which enters the encapsulation material substantially completely - i.e. it absorbs at least 90% of that radiation, in particular at least 95 % of that radiation - and emits wavelength-converted secondary radiation. According to the invention, formation of the multi-component composite comprises forming at least one transverse trench in the first ridge or ridges. Formation of the at least one transverse trench for example comprises a sawing step. In particular, the transverse trench has a main extension direction which is perpendicular to the main extension direction of the first ridge or to a common main extension direction of the first ridges. In an embodiment wherein two first ridges and the carrier body enclose a groove partially or completely filled with encapsulation material, the transverse trench preferably also runs through the encapsulation material.

The at least one transverse trench in particular separates the first ridge or ridges and the encapsulation material, if applicable, into at least two separate sections, the two separate sections following each other along the main extension direction of the first ridge(s). If the chip mounting regions are arranged in rows and columns, the trench preferably runs between two adjacent rows of chip mounting regions. In particular, two transverse trenches are formed which laterally sandwich one row of chip mounting regions.

In another embodiment, formation of the multi-component composite further comprises producing at least one second ridge on the chip mounting surface, the second ridge preferably being arranged between two adjacent chip mounting regions. In particular, at least two second ridges are produced on the chip mounting surface, the second ridges laterally sandwiching at least one chip mounting region. The at least two second ridges are preferably extending parallel to one another. In an expedient development, the second ridge(s) are opaque.

The second ridge(s) extend at an angle to the first opaque ridges, i.e. the second ridge(s) are not parallel to the first ridge(s). In particular, a main extension direction of the second ridge or a common main extension direction of the second ridges is perpendicular to the main extension direction of the first ridge or to the common main extension direction of the first ridges. If the chip mounting regions are arranged in rows and columns, the at least one second ridge preferably extends between two rows of chip mounting regions and/or one row of chip mounting regions is laterally sandwiched by two subsequent second ridges. In a preferred development, the first and second ridges form a grid with a plurality of grid cells, each grid cell comprising one chip mounting region.

The first and/or second ridge(s) can be formed from a plastic material, for example. In principle, the first and second ridges can be formed in one process step, for example by casting or molding with a single mold having a cavity with the inverse shape of the first and second ridges. However, according to the invention, the second ridge (s) are formed in a method step subsequent to the formation of the first ridge(s). Subsequent formation of the first and second ridges can advantageously be effected particularly cost effective. For example, the first and/or second ridge(s) can be formed with an extrusion process. Forming the first and/or second ridge(s) with a casting process or a molding process like an injection molding or transfer molding process is conceivable, too. In this case, the mold can advantageously have a comparably simple form. For example, it can have one or more cavities in the form of a channel. In one development, only one first / second ridge or one subset of the first / second ridges, the subset comprising a plurality of first / second ridges, is formed at a time.

In an expedient development, at least a portion of at least one second ridge, in particular at least a portion of each second ridge is formed in one transverse trench. The portion of the second ridge fills the respective transverse trench at least partially. Preferably, each transverse trench is completely filled by one second ridge and/or each second ridge is completely comprised in one transverse trench. In particular, the transverse trenches act as a mold for the formation of the second ridges. Such second ridges can advantageously be formed in a simple and cost efficient fashion, for example by filling the transverse trenches with a plastic material.

In a preferred embodiment, separation of the multi-component composite into individual semiconductor components comprises effecting at least one second cut through the carrier body and the at least one second ridge along a main extension direction of the second ridge. In particular, a plurality of second cuts is effected, each second cut running through the carrier body and one second ridge along the common main extension direction of the second ridges.

In another embodiment, the first ridge(s) is/are provided with microstructures. For example, the first rige(s) is/are formed by casting or molding with a mold and the surface of the mold is provided with the inverse of the microstructures. The microstructures are expediently provided for scattering and/or diffracting radiation emitted or received by the optoelectronic semiconductor chip. Basic elements of the microstructure have, for example dimensions of 200 nm or more and/or of 5 µm or less. A person skilled in the art knows such scattering and/or diffractive microstructures in principle.

In one embodiment, each of the first ridges has at least one inclined or curved side face. The inclined or curved side face is in particular proximate to the sandwiched chip mounting region. The inclined or curved side face can advantageously act as a reflector for the radiation emitted and/or received by the optoelectronic semiconductor chip in operation of the component. In one development, the inclination angle or the curvature of the inclined or curved side face, the material of the first side wall and the encapsulation material are selected such that at least some radiation - in particular radiation emitted from the optoelectronic semiconductor chip - incident on the interface between the encapsulation material and the inclined or curved side face is reflected by total internal reflection.

In another embodiment, each of the two second ridges has at least one side face which is facing the sandwiched chip mounting region and is perpendicular to the chip mounting surface. Such second ridges can advantageously be formed in a simple and cost efficient fashion by forming the transverse trenches and filling the transverse trenches with the material of the second ridges.

In one embodiment, the first ridges and/or the second ridges are opaque. An opaque ridge in particular transmits at most 10 %, preferably 5 % or less, of the electromagnetic radiation incident on the ridge, at least for electromagnetic radiation with wavelengths which are suitable for emission or reception by the optoelectronic semiconductor chip.

In a preferred embodiment, the first and/or second ridges comprise a reflective material. For example, the first and/or second ridges comprise a white plastic material. Alternatively or in addition, the first and/or second ridges comprise particles in a matrix which have a higher refractive index than the matrix. For example, the matrix comprises a plastic material such as an epoxy resin or a silicone resin. The particles are TiO₂ or SiO₂ particles, for example.

With advantage, the method according to the present application allows for production of semiconductor components having a reflector cup, which is in particular composed of portions of the first ridges and sections of the second ridges, and at the same time having a particularly small size. For example, the semiconductor component has maximum lateral dimensions of 6 mm or less, preferably of 3 mm or less. The semiconductor components according to the present application are particularly well suited for being used in cellular phones.

In a preferred embodiment of the method, formation of the multi-component composite comprises mounting at least one optoelectronic semiconductor chip in at least one chip mounting region, preferably in the chip mounting region(s) which is/are sandwiched by the first or by the first and second ridges. The semiconductor chip is preferably mounted in the chip mounting region after formation of first ridges. In particular it is mounted prior to filling the groove(s) with encapsulation material and/or prior to formation of second ridge(s).

In one embodiment, first and/or second cuts are effected, which are wider where they cut through the first or second ridge than where they cut through the carrier body. In other words, the cut has a larger cross-section in the region of the first or second ridge than in the region of the carrier body. In this way, portions of the carrier body, which have been covered by the first or second ridge during formation of the multi-component composite, can be exposed by the cuts when the composite is separated.

Further, an optoelectronic semiconductor component is disclosed. The optoelectronic semiconductor component comprises a carrier substrate with a chip mounting surface comprising a chip mounting region. The carrier substrate is in particular a section of the carrier body assigned to the semiconductor component. The semiconductor component further comprises an optoelectronic semiconductor chip on the chip mounting region.

The expression "optoelectronic semiconductor component" denotes an electronic component provided for emission and/or detection of electromagnetic radiation by way of an optoelectronic semiconductor chip. An electronic component is a basic electronic element that is packaged in a discrete form with two or more external electrical contact leads or contact pads. Electronic components are in particular intended to be connected together, for example by soldering to a printed circuit board, to create an electronic circuit with a particular function.

A frame member, in particular an opaque frame member, is arranged on the carrier substrate. The frame member laterally surrounds an opening in which the chip mounting region is arranged. In particular, the frame member completely surrounds the chip mounting region in top view of the chip mounting surface. Expediently, the frame member comprises portions of two first ridges. Preferably, the frame member also comprises sections of two second ridges. According to the invention, the frame member is composed two first side walls and two second side walls. Each of the side walls is comprised by an individual part of the frame member. The individual parts are in particular discrete parts which are manufactured separately. At least two individual parts preferably adjoin each other at a common interface. The common interface can, for example, have irregularities like sawing traces. According to the invention, the frame member has at least a first side wall having an inclined or curved side face facing the semiconductor chip. The first side wall is in particular comprised by a portion of a first ridge. The frame member has a second side wall with a side face facing the semiconductor chip that extends perpendicular to the chip mounting surface. The second side wall is in particular comprised by a section of a second ridge.

The inclined or curved side face is provided with scattering and/or diffractive microstructures in one development. The side face of second side wall facing the chip mounting region is free of and/or diffractive microstructures in a further development.

In another embodiment, the frame member and the carrier substrate are laterally flush at least on one side.

The distance of the semiconductor chip from the frame member can be advantageously selected to be particularly small for semiconductor components manufactured with the method according to the present application. For example, the distance between at least one first side wall and the LED chip and/or the distance between at least one second side walls and the LED chip has a value of 0.2 mm or less, in particular of 0.1 mm or less.

In one embodiment, the semiconductor component is comprised by a cellular phone. For example, the semiconductor component represents a flashlight of the cellular phone.

Advantageous embodiments and developments of the method and the semiconductor component will become apparent from the exemplary embodiments described below in association with the figures.

In the figures:
Figure 1 shows a schematic top view of a detail of a multi-component composite during a first step of the method according to an exemplary embodiment,
Figure 2A shows a schematic cross section of a detail of the multi-component composite during a second step of the method according to the exemplary embodiment,
Figure 2B shows a schematic cross section of a detail the multi-component composite during the second step of the method according to a variant of the exemplary embodiment,
Figure 3 shows a schematic cross section of a detail of the multi-component composite during a third step of the method according to the exemplary embodiment,
Figure 4 shows a schematic top view of a detail of the multi-component composite during a fourth step of the method according to the exemplary embodiment,
Figure 5 shows a schematic perspective view of the multi-component composite during a fifth step of the method according to the exemplary embodiment,
Figure 6 shows a schematic top view of the multi-component composite during a sixth step of the method according to the exemplary embodiment,
Figure 7 shows a schematic sectional view of the multi-component composite during a seventh step of the method according to the exemplary embodiment,
Figures 8A-8H show schematic sectional views of different embodiments of first ridges, and
Figure 9 shows a schematic top view of a semiconductor component according to a second exemplary embodiment.

In the exemplary embodiments and figures, similar or similarly acting constituent parts are provided with the same reference symbols. The elements illustrated in the figures and their size relationships among one another should not be regarded as true to scale. Rather, individual elements may be represented with an exaggerated size for the sake of better representability and/or for the sake of better understanding.

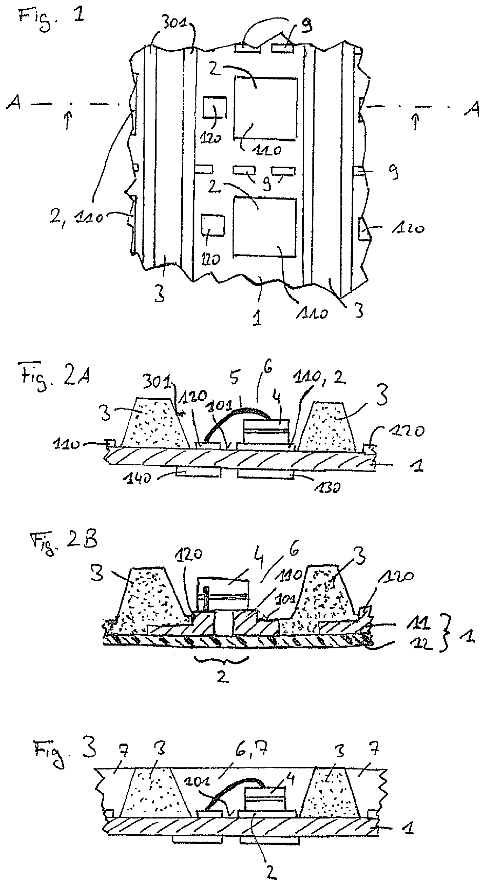

As illustrated in Figure 1, which shows a schematic top view of a detail of a multi-component composite 18 during a first step of the method according to one exemplary embodiment, a carrier body 1 is provided. The carrier body 1 in the present embodiment is a printed circuit board. The multi-component composite 18 has, for example, maximum lateral dimensions - i.e. in particular maximum dimensions in top view of the carrier body - of 101.6 mm or less, in particular of 50.8 mm or less, which dimensions are also suitable for other embodiments.

The circuit board 1 has first conductor tracks 110 and second conductor tracks 120 on a chip mounting surface 101. On its side opposite the chip mounting surface 101, the circuit board 1 has first and second external electrical contact pads 130, 140 (see Fig. 2A). Each first external electrical contact pad 130 is electrically connected to a first conductor track 110 and each second external electrical contact pad 140 is electrically connected to a second conductor track 120. The external electrical contact pads 130, 140 are provided for feeding an operating current into the future semiconductor components during their operation.

Chip mounting regions 2 are provided on the chip mounting surface 101. In the present embodiment, chip mounting regions 2 are represented by first conductor tracks 110 of the circuit board 1. The chip mounting regions 2 are arranged in a matrix having a plurality of rows and columns in the present embodiment.

A plurality of first opaque ridges 3 is formed on the chip mounting surface 101 of the carrier body 1. For example, the first ridges 3 are formed from a white plastic material. Formation of the first ridges 3 in particular comprises a molding process.

In the present embodiment, a mold with a plurality of cavities is pressed onto the chip mounting surface 101. The cavities each have the form of a channel, the channel having the inverse shape of a first ridge 3. The form is positioned such that two subsequent channels laterally enclose one column of chip mounting regions 2.

Subsequently, the viscous plastic material is injected into the channels and hardened so that the first ridges 3 are formed. After that, the form is removed, leaving the first ridges 3 on the chip mounting surface 101. Each two subsequent first ridges 3 laterally enclose or, in other words, laterally sandwich one column of chip mounting regions 2.

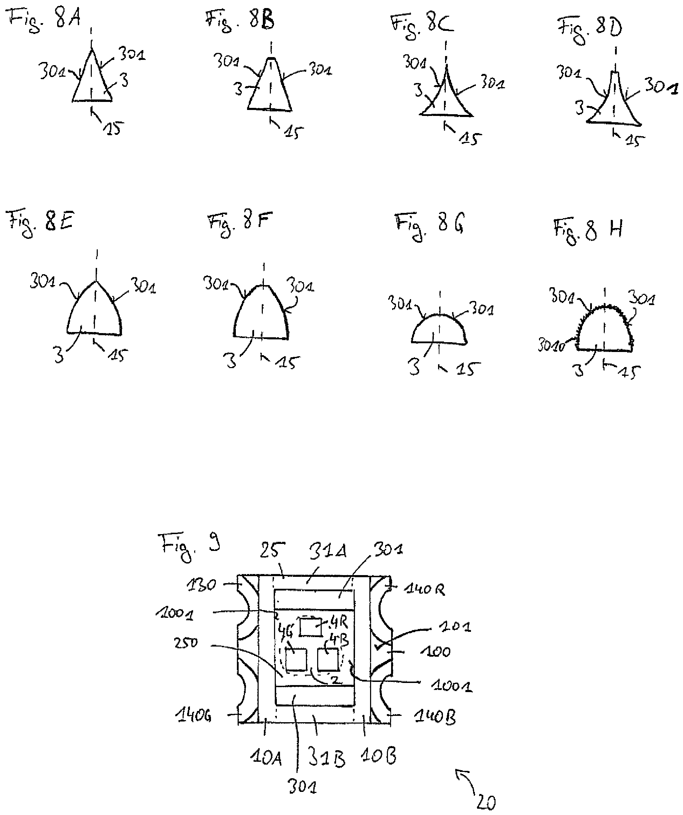

In the present embodiment, the first ridges 3 have a trapezoidal cross section as shown in Figure 8B. More specifically, the cross section has the form of an isosceles trapezoidal with the longer of the two parallel sides proximate to the chip mounting surface 101.

Figures 8A and 8C-8H show schematic sectional views of alternative embodiments of first ridges 3. The cross section according to Fig. 8A has the form of a triangle, in particular an isosceles triangle. The cross sections according to Figures 8C and 8E have the form of isosceles triangles with a basis which is a straight line proximate to the chip mounting surface 101 and legs which are not straight lines but have a concave (Fig. 8C) or convex (Fig. 8E) curvature. The cross sections according to Figures 8D and 8F basically correspond to the cross section of Fig. 8B which has the form of an isosceles trapezoid. In contrast to the latter cross section, the legs of the trapezoids according to Figures 8D and 8F have a concave (Fig. 8D) or convex (Fig. 8F) curvature. The cross section according to Fig. 8G has a semicircular form. The cross section according to Fig 8H has the form of a portion of an ellipse.

First ridges 3 having cross sections according to Figures 8A or 8B have inclined side faces 301. First ridges 3 having cross section according to Figures 8C to 8H have curved side faces 301.

In each case, the side faces 301 of the first ridges 3 - corresponding to the legs of their cross sections - can be provided with a radiation scattering and/or diffractive microstructure 3010. As an example, side faces 301 with a radiation scattering microstructure 3010 are illustrated in Figure 8H.

In Figure 2A, which is a schematic cross section along the line A-A of Fig. 1, a second step of the method according to the exemplary embodiment is illustrated. In the second step, an optoelectronic semiconductor chip 4, in particular an LED-chip, is mounted in one chip mounting region 2. In particular, at least one optoelectronic semiconductor component 4 is mounted in each chip mounting region 2.

In one embodiment, the inclination angle of the side faces 301 of the first ridges is selected such that at least some light emitted by the LED-chip 4 in operation can be totally internally reflected at the side faces 301.

The LED-chip 4 is, for example, soldered or adhesively bonded to the first conductor track 110, such that the LED-chip 4 is electrically connected and mechanically fixed to first the conductor track 110. A second electrical connection is established between the LED-chip 4 and a second conductor track 120 proximate to the first conductor track 110 by means of a bonding wire 5. The bonding wire 5 is attached to a side of the LED-chip 4 remote from the carrier body 1. It is a gold or aluminum wire, for example.

Alternatively, the optoelectronic semiconductor chip 4 can be designed to have both electrical connections on one side. For example it can be provided for so-called "flip chip" mounting. In this case, the chip mounting region 2 can, for example, comprise one first and one second conductor track 110, 120. This is illustrated in exemplary fashion in the schematic cross section of Figure 2B, which shows a detail of the multi-component composite 18 during the second step of the method according to a variant of the exemplary embodiment.

According to the variant illustrated in Figure 2B, the carrier body 1 is not a circuit board. Instead, the carrier body 1 is composed of a lead frame 11 and a continuous film 12. The continuous film 12 preferably comprises a plastic film. In the present variant of the method, it is attached - for example adhesively bonded - to the lead frame 11 on the side opposite of the chip mounting surface. The continuous film 12 advantageously closes openings of the lead frame 11 so that plastic material cannot escape through the carrier body 1 during formation of the first ridges 3.

As shown in the schematic cross section Figure 3, formation of the multi-component composite 18 according to the exemplary embodiment of the method continues with filling the grooves 6 which are defined by a pair of subsequent first ridges 3 and the carrier body 1 with a transparent encapsulation material 7. In a variant, the encapsulation material 7 can comprise phosphor particles such as YAG:Ce-particles and/or diffuser particles. The encapsulation material 7 is in the form of a string, each string covering a column of chip mounting regions 2 in top view of the chip mounting surface 101.

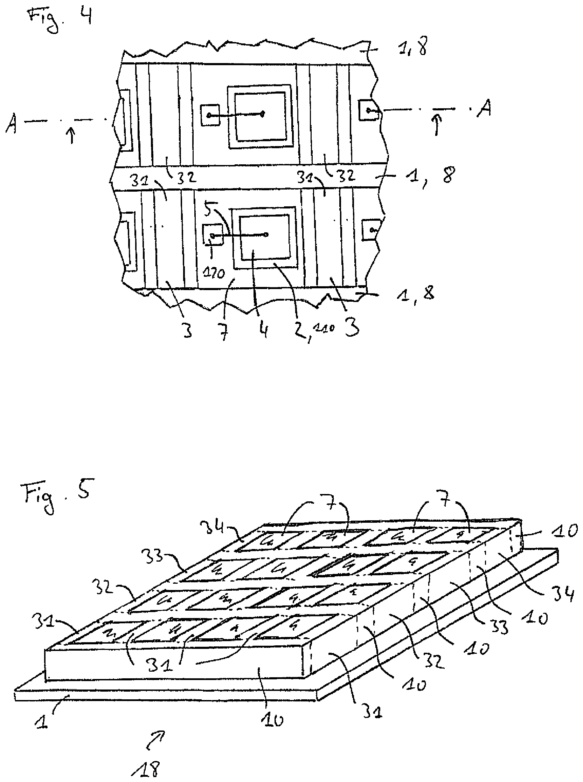

Figure 4 shows a schematic top view of a detail of the multi-component composite 18 during a fourth step of the method according to the exemplary embodiment. In this step, transverse trenches 8 are formed in the first ridges 3 and in the strings of encapsulation material 7, for example by cutting with a saw blade.

In one development, the carrier body is provided with alignment labels 9 (see Fig. 1). The alignment labels 9 are provided in the regions where the transverse trenches 8 are formed in the fourth method step. For example, the saw blade can be aligned using the alignment labels 9 in order to cut the transverse trenches 8. In this way, the risk of damaging the mounted semiconductor chips 4 during formation of the transverse trenches 8 can be advantageously reduced. Such alignment labels 9 are suitable for other embodiments of the method, as well.

Preferably, the material of the first ridges 3 and the encapsulation material 7 are completely removed in the region of the transverse trenches, such that the carrier body 1 is exposed. The transverse trenches 8 preferably do not completely cut through the carrier body 1, i.e. the carrier body 1 preferably is not divided by cutting the transverse trenches 8.

In the present embodiment, the transverse trenches 8 have a main extension direction which is perpendicular to the main extension direction of the first ridges 3. Each transverse trench 8 extends between two adjacent rows of chip mounting regions. In particular, each two adjacent transverse trenches 8 laterally sandwich one row of chip mounting regions 2.

The transverse trenches 8 divide the first ridges 3 into individual sections 31, 32, 33, 34. The sections 31, 32, 33, 34 of each first ridge 3 follow each other along the main extension direction of the first ridges 3. In particular, each section 31, 32, 33, 34 is assigned to one row of chip mounting regions 2.

In a subsequent method step, illustrated in the schematic perspective view of Figure 5, the transverse trenches 8 are filled up completely with white plastic material, so that second opaque ridges 10 are formed. Preferably, additional second opaque ridges 10 are formed at either end of the first ridges 3. In this way, each pair of subsequent second ridges 10 laterally sandwiches one row of chip mounting regions 2. The second ridges 10 and the sections 31, 32, 33, 34 of the first ridges 3 form a rectangular grid. Each cell of the grid comprises one chip mounting region 2.

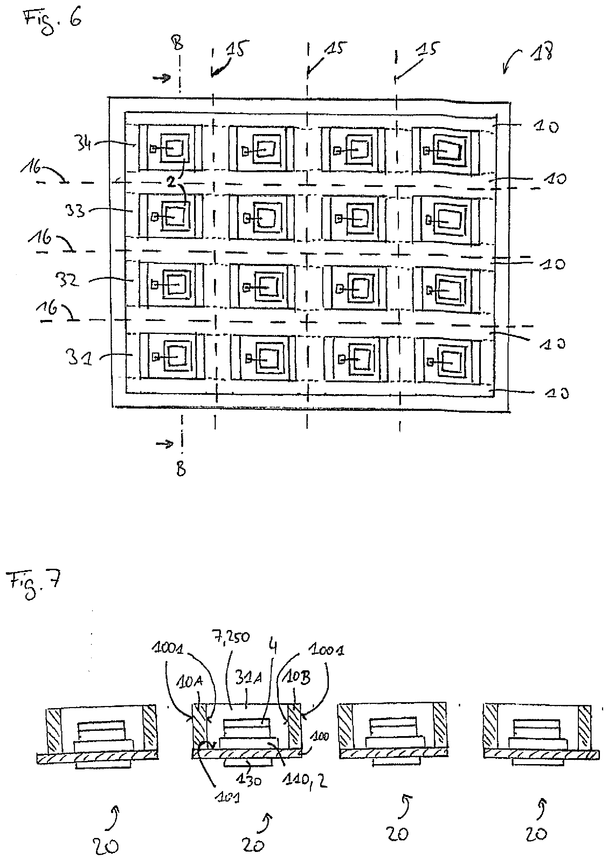

Figure 6 shows the multi-component composite 18 in a schematic top view during a sixth step of the method according to the exemplary embodiment. In the sixth step, the multi-component composite 18 is separated into individual optoelectronic semiconductor components 20.

Separation is effected by first cuts 15 through the carrier body 1 and the first ridges 3 and by second cuts 16 through the carrier body 1 and the second ridges 10. The first cuts 15 run along the main extension direction of the first ridges 3. The second cuts 16 run along the main extension direction of the second ridges 10. Each first cut 15 divides each section 31, 32, 33, 34 of one first ridge 3 into two portions, each portion being assigned to one semiconductor component 20. Each second cut 16 divides each second ridge 10 into two portions, each portion being assigned to one row of semiconductor components. The first cuts 15 and/or the second cuts 16 have, for example, a width - i.e. in particular a lateral dimension perpendicular to the main extension direction of the first / second ridges - of 0.2 mm or less and in particular of 0.1 mm or less. These widths are suitable for other embodiments, as well.

Figure 7 shows a schematic sectional view along the line B-B of Fig. 6. In Fig. 7, the optoelectronic semiconductor components 20 are illustrated after separation of the multi-component composite 18 by the first and second cuts 15, 16.

Each component 20 has a carrier substrate 100, which is a portion of the carrier body 1, cut out from the latter by a set of first and second cuts 15, 16. It further has a frame member 25 which is composed of two first side walls 31A, 31B and two second side walls 10A, 10B. Each of the first side walls 31A, 31B corresponds to one of the portions of a section 31 of a first ridge 3. Each second side wall 10A, 10B corresponds to a section of one portion of a second side wall 10.

The frame member 25, i.e. the first and second side walls 31A, 31B, 10A, 10B laterally surround an opening 250 in which the chip mounting region 2 is arranged. In this way, the frame member 25 acts as a reflector cup for the radiation emitted by the LED-chip 4. The opening 250 is filled with the encapsulation material 7.

The first side walls 31A, 31B each have an inclined side face facing the LED-chip 4. The side faces 1001 of the second side walls 10A, 10B are perpendicular to the chip mounting surface 101.

The frame member 25 and the carrier substrate 100 are laterally flush at least on one side of the semiconductor component. In particular, at least one side face of the semiconductor component 20 is a flat side face and comprises a side face of the carrier substrate 100 and a side face of one of the first or second side walls 31A, 31B, 10A, 10B

Figure 9 illustrates a second exemplary embodiment of an optoelectronic semiconductor component in a schematic top view of the semiconductor component 20.

In contrast to the semiconductor component according to the first exemplary embodiment, the semiconductor component 20 according to the second exemplary embodiment comprises a plurality of semiconductor chips 4. For example, it comprises at least one optoelectronic semiconductor chip 4R provided for emitting red light, at least one optoelectronic semiconductor chip 4G provided for emitting green light and/or at least one optoelectronic semiconductor chip 4B provided for emitting blue light. In the present embodiment, the semiconductor component comprises one red emitting LED-chip 4R, one green emitting LED-chip 4G and one blue emitting LED-chip 4B.

The component 20 comprises, for example, a common first external electrical contact pad 130 and individual second external electrical contact pads 140R, 140G, 140B for each of the semiconductor chips 4R, 4G, 4B.

The first and second external electrical contact pads 130, 140R, 140G, 140B do not have to be arranged on the side opposite the chip mounting surface 101 of the carrier substrate 100 as exemplary illustrated in connection with the first embodiment. Rather, they can also be arranged sideways of the frame member 25 on the chip mounting surface 101 and/or on at least one side face of the carrier substrate 100. In the second embodiment, the first and second external electrical contact pads 130, 140R, 140G, 140B are arranged on the chip mounting surface 101 sideways of the second side walls 10A, 10B and on two opposite side faces of the carrier substrate 100.

For example, the portions of the chip mounting surface 101 sideways of the second side walls 10A, 10B remote from the chip mounting region 2 are exposed by effecting second cuts 16 which have a wider cross section in the region of the second side walls 10 than in the region of the carrier body 1. For example, the second cuts 16 are made with a saw blade having a stepped profile.

First cuts 15 can be carried out in the same fashion for exposing portions of the carrier substrate 100 sideways of the first sidewalls 31A, 31B. In the present embodiment, however, the first sidewalls 31A, 31B and the carrier substrate 100 are laterally flush.

The invention is not restricted to the exemplary embodiments by the description on the basis of said exemplary embodiments. Rather, the scope of the invention is defined by the appended claims.

## Claims

1. Method for producing a plurality of optoelectronic semiconductor components, comprising formation of a multi-component composite (18) and separation of the multi-component composite into individual semiconductor components (20),
wherein
- formation of the multi-component composite (18) comprises providing a carrier body (1) having a chip mounting surface (101) with a plurality of chip mounting regions (2), each chip mounting region (2) being provided for mounting at least one optoelectronic semiconductor chip (4) and being assigned to one optoelectronic semiconductor component (20);
- formation of the multi-component composite (18) comprises forming at least two first opaque ridges (3) on the chip mounting surface (101), the two first ridges (3) laterally sandwiching at least one chip mounting region (2); and
- separation of the multi-component composite (18) into individual semiconductor components (20) comprises effecting first cuts (15) through the carrier body (1) and the first ridges along a main extension direction of the first opaque ridges (3)
**characterized in that**
- formation of the multi-component composite (18) comprises producing at least two second opaque ridges (10) on the chip mounting surface,
wherein the second ridges (10) laterally sandwich at least one chip mounting region (2) and extend at an angle of > 0° to the main extension direction of the first ridges (3), and
wherein at least two transverse trenches (8) are formed in the first ridges (3) and at least a portion of each second ridge (10) is formed in one transverse trench (8) and fills the respective transverse trench (8).

2. The method of claim 1, wherein the two first ridges (3) and the carrier body (1) define a groove (6) comprising the sandwiched chip mounting region (2) and formation of the multi-component composite (18) further comprises filling the groove (6) with a radiation transmitting encapsulation material (7).

3. The method of one of the two preceding claims, wherein separation of the multi-component composite (18) into individual semiconductor components (20) comprises effecting second cuts (16) through the carrier body (1) and the second opaque ridges (10) along a main extension direction of the second opaque ridges (10).

4. The method of one of the preceding claims, wherein the first ridges (3) are provided with diffractive and/or scattering microstructures.

5. The method of one of the preceding claims, wherein each of the first ridges (3) has at least one inclined or curved side face (301) and each of the second ridges (10) has at least one side face (1001) which is facing the sandwiched chip mounting region (2) and extends perpendicular to the chip mounting surface (101).

6. The method of one of the preceding claims, wherein the first and/or second ridges (3, 10) comprise a reflective material.

7. The method of one of the preceding claims, wherein formation of the multi-component composite (18) comprises mounting at least one optoelectronic semiconductor chip (4) at least in the chip mounting region (2) sandwiched by the first or by the first and second ridges (3, 10).

8. The method of one of the preceding claims, wherein first and/or second cuts (15, 16) are effected which have a larger cross section in the region of the first or second ridge (3, 10) than in the region of the carrier body (1).

9. Optoelectronic semiconductor component (20) comprising:
- a carrier substrate (100) with a chip mounting surface (101) comprising a chip mounting region (2);
- an optoelectronic semiconductor chip (4, 4R, 4G, 4B) on the chip mounting region (2); and
- an opaque frame member (25) on the carrier substrate (100), the frame member (25) laterally surrounding an opening (250) in which the chip mounting region (2) is arranged, wherein
the frame member (25) has at least a first side wall (31A, 31B) having an inclined or curved side face (301) facing the semiconductor chip (4, 4R, 4G, 4B) and a second side wall (10A, 10B) with a side face (1001) facing the semiconductor chip (4, 4R, 4G, 4B) that runs perpendicular to the chip mounting surface (101) **characterized in that**
- the frame member (25) comprises two first side walls (31A, 31B) and two second side walls (10A, 10B), each side wall (31A, 31B, 10A, 10B) comprised by an individual separately manufactured part of the frame member (25).

10. The optoelectronic semiconductor component (20) of the preceding claim, wherein the inclined or curved side face (301) is provided with diffractive microstructures.

11. The optoelectronic semiconductor component of one of the two preceding claims, wherein the frame member (25) and the carrier substrate (100) are laterally flush at least on one side.

## Patentansprüche

1. Verfahren zur Herstellung einer Vielzahl optoelektronischer Hableiterbauteile, umfassend das Bilden eines Mehrkomponentenverbunds (18) und Trennen des Mehrkomponentenverbunds in einzelne Halbleiterbauteile (20), wobei
- das Bilden des Mehrkomponentenverbunds (18) das Bereitstellen eines Trägerkörpers (1) mit einer ChipBefestigungsfläche (101) mit einer Vielzahl von Chip-Befestigungsbereichen (2) umfasst, wobei jeder Chip-Befestigungsbereich (2) zum Befestigen von zumindest einem optoelektronischen Halbleiterchip (4) vorgesehen und einem optoelektronischen Halbleiterbauteil (20) zugeordnet ist;
- das Bilden des Mehrkomponentenverbunds (18) das Bilden von zumindest zwei ersten opaken Stegen (3) auf der ChipBefestigungsfläche (101) umfasst, wobei die beiden ersten Stege (3) seitlich zumindest einen Chip-Befestigungsbereich (2) sandwichartig umgeben (2); und
- das Trennen des Mehrkomponentenverbunds (18) in einzelne Halbleiterbauteile (20) das Bewirken erster Schnitte (15) durch den Trägerkörper (1) und die ersten Stege entlang einer Haupterstreckungsrichtung der ersten opaken Stege (3) umfasst,
**dadurch gekennzeichnet, dass**
- das Bilden des Mehrkomponentenverbunds (18) das Herstellen von zumindest zwei zweiten opaken Stegen (10) auf der Chipbefestigungsfläche umfasst,
wobei die zweiten Stege (10) seitlich zumindest einen Chipbefestigungsbereich (2) sandwichartig umgeben und sich in einem Winkel von > 0° zur Haupterstreckungsrichtung der ersten Stege (3) erstrecken, und
wobei zumindest zwei Quergräben (8) in den ersten Stegen (3) gebildet werden und zumindest ein Teil von jedem zweiten Steg (10) in einem Quergraben (8) gebildet wird und den jeweiligen Quergraben (8) ausfüllt.

2. Verfahren nach Anspruch 1, wobei die beiden ersten Stege (3) und der Trägerkörper (1) eine Nut (6) definieren, die den sandwichartig umschlossenen Chipbefestigungsbereich (2) aufweist, und das Bilden des Mehrkomponentenverbunds (18) ferner das Füllen der Nut (6) mit einem strahlungsdurchlässigen Verkapselungsmaterial (7) umfasst.

3. Verfahren nach einem der beiden vorstehenden Ansprüche, wobei das Trennen des Mehrkomponentenverbunds (18) in einzelne Halbleiterbauteile (20) das Bewirken zweiter Schnitte (16) durch den Trägerkörper (1) und die zweiten opaken Stege (10) entlang einer Haupterstreckungsrichtung der zweiten opaken Stege (10) umfasst.

4. Verfahren nach einem der vorstehenden Ansprüche, wobei die ersten Stege (3) mit beugenden und/oder streuenden Mikrostrukturen versehen sind.

5. Verfahren nach einem der vorstehenden Ansprüche, wobei jeder der ersten Stege (3) zumindest eine schräge oder gekrümmte Seitenfläche (301) besitzt und jeder der zweiten Stege (10) zumindest eine Seitenfläche (1001) besitzt, die dem sandwichartig umschlossenen Chipbefestigungsbereich (2) zugewandt ist und sich senkrecht zur Chipbefestigungsfläche (101) erstreckt.

6. Verfahren nach einem der vorstehenden Ansprüche, wobei die ersten und/oder zweiten Stege (3, 10) ein reflektierendes Material aufweisen.

7. Verfahren nach einem der vorstehenden Ansprüche, wobei das Bilden des Mehrkomponentenverbunds (18) das Befestigen von zumindest einem optoelektronischen Halbleiterchip (4) zumindest in dem Chipbefestigungsbereich (2), der sandwichartig von dem ersten Steg oder von den ersten und zweiten Stegen (3, 10) umschlossen wird, umfasst.

8. Verfahren nach einem der vorstehenden Ansprüche, wobei erste und/oder zweite Schnitte (15, 16) bewirkt werden, die im Bereich des ersten oder zweiten Stegs (3, 10) einen größeren Querschnitt besitzen als in dem Bereich des Trägerkörpers (1).

9. Optoelektronisches Halbleiterbauteil (20), aufweisend:
- ein Trägersubstrat (100) mit einer Chipbefestigungsfläche (101) aufweisend einen Chipbefestigungsbereich (2);
- einen optoelektronischen Halbleiterchip (4, 4R, 4G, 4B) auf dem Chipbefestigungsbereich (2); und
- ein opakes Rahmenglied (25) auf dem Trägersubstrat (100), wobei das Rahmenglied (25) eine Öffnung (250), in der der Chipbefestigungsbereich (2) angeordnet ist, seitlich umgibt, wobei
- das Rahmenglied (25) zumindest eine erste Seitenwand (31A, 31B) mit einer dem Halbleiterchip (4, 4R, 4G, 4B) zugewandten, schrägen oder gekrümmten Seitenfläche (301) und eine zweite Seitenwand (10A, 10B) mit einer dem Halbleiterchip (4, 4R, 4G, 4B) zugewandten Seitenfläche (1001), die senkrecht zur Chipbefestigungsfläche (101) verläuft, besitzt,
**dadurch gekennzeichnet, dass**
- das Rahmenglied (25) zwei erste Seitenwände (31A, 31B) und zwei zweite Seitenwände (10A, 10B) aufweist, wobei jede Seitenwand (31A, 31B, 10A, 10B) von einem einzelnen, getrennt hergestellten Teil des Rahmenglieds (25) umfasst ist.

10. Optoelektronisches Halbleiterbauteil (20) nach dem vorstehenden Anspruch, wobei die schräge oder gekrümmte Seitenfläche (301) mit beugenden Mikrostrukturen versehen ist.

11. Optoelektronisches Halbleiterbauteil nach einem der beiden vorstehenden Ansprüche, wobei das Rahmenglied (25) und das Trägersubstrat (100) an zumindest einer Seite seitlich bündig sind.

## Revendications

1. Procédé de production d'une pluralité de composants semi-conducteurs optoélectroniques, comprenant la formation d'un composite à plusieurs composants (18) et la séparation d'un composite à plusieurs composants en composants semi-conducteurs individuels (20),
dans lequel
- la formation du composite à plusieurs composants (18) comprend la prévision d'un corps de support (1) présentant une surface de montage de puce (101) avec une pluralité de régions de montage de puce (2), chaque région de montage de puce (2) étant prévue pour monter au moins une puce semi-conductrice optoélectronique (4) et étant attribuée à un composant semi-conducteur optoélectronique (20) ;
- la formation du composite à plusieurs composants (18) comprend la formation d'au moins deux premières crêtes opaques (3) sur la surface de montage de puce (101), les deux premières crêtes (3) prenant en sandwich latéralement au moins une région de montage de puce (2), et
- la séparation du composite à plusieurs composants (18) en composants semi-conducteurs individuels (20) comprend la réalisation de premières coupes (15) à travers le corps de support (1) et les premières crêtes le long d'une direction d'extension principale des premières crêtes opaques (3),
**caractérisé en ce que**
- la formation du composite à plusieurs composants (18) comprend la production d'au moins deux secondes crêtes opaques (10) sur la surface de montage de puce,
dans lequel les secondes crêtes (10) prennent latéralement en sandwich au moins une région de montage de puce (2), et s'étendent selon un angle > 0° par rapport à la direction d'extension principale des premières crêtes (3), et dans lequel aux moins deux tranchées transversales (8) sont formées dans les premières crêtes (3), et au moins une portion de chaque seconde crête (10) est formée dans une tranchée transversale (8) et remplit la tranchée transversale respective (8).

2. Procédé selon la revendication 1, dans lequel les deux premières crêtes (3) et le corps de support (1) définissent une rainure (6) comprenant la région de montage de puce prise en sandwich (2), et la formation du composite à plusieurs composants (18) comprend en outre le remplissage de la rainure (6) avec un matériau d'encapsulation transmettant les rayonnements (7).

3. Procédé selon l'une quelconque des revendications précédentes, dans lequel la séparation du composite à plusieurs composants (18) en composants semi-conducteurs individuels (20) comprend la réalisation de secondes coupes (16) à travers le corps de support (1) et les secondes crêtes opaques (10) le long d'une direction d'extension principale des secondes crêtes opaques (10).

4. Procédé selon l'une quelconque des revendications précédentes, dans lequel les premières crêtes (3) sont dotées de microstructures diffractives et/ou de diffusion.

5. Procédé selon l'une quelconque des revendications précédentes, dans lequel chacune des premières crêtes (3) présente au moins une face latérale inclinée ou incurvée (301), et chacune des secondes crêtes (10) présente au moins une face latérale (1001), faisant face à la région de montage de puce en sandwich (2), et s'étend perpendiculairement à la surface de montage de puce (101).

6. Procédé selon l'une quelconque des revendications précédentes, dans lequel les premières et/ou secondes crêtes (3, 10) comprennent un matériau réflecteur.

7. Procédé selon l'une quelconque des revendications précédentes, dans lequel la formation du composite à plusieurs composants (18) comprend le montage d'au moins une puce semi-conductrice optoélectronique (4) au moins dans la région de montage de puce (2) prise en sandwich par les premières, ou par les premières et secondes crêtes (3, 10).

8. Procédé selon l'une quelconque des revendications précédentes, dans lequel les premières et secondes coupes (15, 16) sont réalisées, lesquelles présentent une section transversale plus grande dans la région des premières ou secondes crêtes (3, 10) que dans la région du corps de support (1).

9. Composant semi-conducteur optoélectronique (20), comprenant :
- un substrat de support (100) doté d'une surface de montage de puce (101) comprenant une région de montage de puce (2) ;
- une puce semi-conductrice (4, 4R, 4G, 4B) sur la région de montage de puce (2), et
- un élément de cadre opaque (25) sur le substrat de support (100), l'élément de cadre (25) entourant latéralement une ouverture (250) dans laquelle est agencée la région de montage de puce (2), dans lequel
- l'élément de cadre (25) présente au moins une première paroi latérale (31A, 31B) présentant une face latérale inclinée ou incurvée (301) faisant face à la puce semi-conductrice (4, 4R, 4G, 4B) et une seconde paroi latérale (10A, 10B) présentant une face latérale (1001) faisant face à la puce semi-conductrice (4, 4R, 4G, 4B) qui s'étend perpendiculaire à la surface de montage de puce (101),
**caractérisé en ce que**
- l'élément de cadre (25) comprend deux premières parois latérales (31A, 31B) et deux secondes parois latérales (10A, 10B), chaque paroi latérale (31A, 31B, 10A, 10B) étant constituée d'une partie individuelle, fabriquée séparément, de l'élément de cadre (25).

10. Composant semi-conducteur optoélectronique (20) selon la revendication précédente, dans lequel la face latérale inclinée ou incurvée (301) est dotée de microstructures diffractives.

11. Composant semi-conducteur optoélectronique selon l'une quelconque des revendications précédentes, dans lequel l'élément de cadre (25) et le substrat de support (100) sont latéralement à ras au moins sur un côté.
